# EUROPEAN PATENT SPECIFICATION

(11) **EP 4 040 338 B1**
(45) Date of publication and mention of the grant of the patent: **15.01.2025**
(21) Application number: 21205146.0
(22) Date of filing: 28.10.2021
(51) Int. Cl.: G06N 3/044, G06N 3/045, G06N 3/047, G06N 3/09, G06N 3/096, G06Q 50/06

(54) **RESTRICTED BOLTZMANN MACHINE BASED SOURCE-SEPARATION MODEL WITH APPLICATION TO LOAD DISAGGREGATION**
AUF EINER BESCHRÄNKTEN BOLTZMANNMASCHINE BASIERTES QUELLENTRENNUNGSMODELL MIT ANWENDUNG AUF DIE LASTENTRENNUNG
MODÈLE DE SÉPARATION DE SOURCE BASÉ SUR UNE MACHINE BOLTZMANN RESTREINTE AVEC APPLICATION POUR LA DÉSAGRÉGATION DE CHARGE

(30) Priority: 04.02.2021 IN 202121004907
(43) Date of publication of application: 10.08.2022
(73) Proprietor: Tata Consultancy Services Limited, Maharashtra (IN)
(72) Inventor: PARESH, SPOORTHY, 560066 Bangalore, Karnataka (IN); THOKALA, NAVEEN, 500081 Hyderabad, Telangana (IN); BRINDAVANAM, VISHNU, 500081 Hyderabad, Telangana (IN); CHANDRA, MARISWAMY GIRISH, 500081 Hyderabad, Telangana (IN)
(74) Representative: Goddar, Heinz J.

(56) References cited:
- SAGAR VERMA ET AL: "Multi Label Restricted Boltzmann Machine for Non-Intrusive Load Monitoring", ARXIV.ORG, CORNELL UNIVERSITY LIBRARY, 201 OLIN LIBRARY CORNELL UNIVERSITY ITHACA, NY 14853, 17 October 2019 (2019-10-17), XP081517241
- MOCANU ELENA: "Machine Learning applied to Smart Grids", 9 October 2017 (2017-10-09), pages 1 - 165, XP055907281, ISBN: 978-90-38-64338-0, Retrieved from the Internet <URL:https://pure.tue.nl/ws/files/77436888/20171009_Mocanu.pdf> [retrieved on 20220330]

## Description

### TECHNICAL FIELD

The disclosure herein generally relates to load disaggregation, and, more particularly, to system and method that implement a Restricted Boltzmann Machine (RBM) based source-separation model with application to load disaggregation.

### BACKGROUND

Over the years, there has been an increase in interest in energy-efficient infrastructures and this is driving the research works in the field of load disaggregation. While attempts are being made to conserve energy, the focus has also been on how best the electricity consumption can be optimized by each appliance. Load disaggregation may be useful in terms of both the consumers and producers of energy. The present-day supervised learning models for load disaggregation necessitate the learning of models for every appliance load of interest, which incurs high computational costs. Also, the amount of training data that is available in real-life is scarce and the models must be built with such a constraint in mind. The presence of common states like motor operation in certain appliances, are likely to make the supervised models vulnerable to errors; therefore, a trade-off between supervised and unsupervised is intended. Such models can easily adapt to Out of Distribution (OOD) which is a necessary criterion for problem at hand. Document *"*Multi Label Restricted Boltzmann Machine for Non-Intrusive Load Monitoring", ARXIV.ORG, CORNELL UNIVERSITY LIBRARY, 201 OLIN LIBRARY CORNELL UNIVERSITY ITHACA, NY 14853, 17 October 2019 (2019-10-17), discloses that an increasing population indicates that energy demands need to be managed in the residential sector. Prior studies have reflected that the customers tend to reduce a significant amount of energy consumption if they are provided with appliance-level feedback. This observation has increased the relevance of load monitoring in today's tech-savvy world. Most of the previously proposed solutions claim to perform load monitoring without intrusion, but they are not completely non-intrusive. These methods require historical appliance-level data for training the model for each of the devices. This data is gathered by putting a sensor on each of the appliances present in the home which causes intrusion in the building. Some recent studies have proposed that if we frame Non-Intrusive Load Monitoring (NILM) as a multi-label classification problem, the need for appliance-level data can be avoided. In this paper, we propose Multi-label Restricted Boltzmann Machine (ML-RBM) for NILM and report an experimental evaluation of proposed and state-of-the-art techniques (*Abstract*)*.* Document (Mocanu Elena: "Machine Learning applied to Smart Grids") discloses Deep Learning has become one of the most important trends in Machine Learning with a wide range of applications. In this chapter, we introduce for the first time its application to energy prediction by proposing three Deep Learning methods. Firstly, a new stochastic model for time series prediction of total building energy consumption and lighting load, namely the Conditional Restricted Boltzmann Machine (CRBM), is introduced in Section 2.2. The assessment is made on a real dataset consisting of 7 weeks of electricity consumption collected with hourly resolution from a Dutch office building. The results of CRBMs are compared with the well-known Artificial Neural Networks (ANNs), and Hidden Markov Models (HMMs). Secondly, we investigate a new deep learning method, namely the Factored Conditional Restricted Boltzmann Machine (FCRBM), and extend its applicability to the energy prediction problem. The assessment is made on a benchmark dataset consisting of almost four years with one minute resolution electric power consumption data collected from an individual residential customer. The results show that for this database, FCRBM outperforms ANN, Support Vector Machine (SVM), Recurrent Neural Networks (RNN) and CRBM. Thirdly, we propose in Section 2.4. a new fusion model for time series prediction of energy consumption in a price-responsive context, based on Restricted Boltzman Machine and FCRBM. The assessment is made on the EcoGrid EU dataset consisting of aggregated electric power consumption, price, and meteorological data collected from 1900 household customers. The results show that for the energy prediction problem solved here, FCRBM outperforms SVM and the persistence method (Abstract).

### SUMMARY

Embodiments of the present disclosure present technological improvements as solutions to one or more of the above-mentioned technical problems recognized by the inventors in conventional systems. In one aspect, there is provided a processor implemented method according to claim 1.

In one aspect, there is provided a system according to claim 2.

In yet another aspect, there are provided one or more non-transitory machine readable information storage mediums according to claim 3.

### BRIEF DESCRIPTION OF THE DRAWINGS

The accompanying drawings, which are incorporated in and constitute a part of this disclosure, illustrate exemplary embodiments and, together with the description, serve to explain the disclosed principles:
FIG. 1 depicts a system for load disaggregation of appliances of interest using a Restricted Boltzmann Machine (RBM) based source-separation model, in accordance with an embodiment of the present disclosure.
FIG. 2 depicts an exemplary flow chart illustrating a method for load disaggregation of appliances of interest using the Restricted Boltzmann Machine (RBM) based source-separation model, using the system of FIG. 1, in accordance with an embodiment of the present disclosure.

### DETAILED DESCRIPTION OF EMBODIMENTS

Exemplary embodiments are described with reference to the accompanying drawings. In the figures, the left-most digit(s) of a reference number identifies the figure in which the reference number first appears. Wherever convenient, the same reference numbers are used throughout the drawings to refer to the same or like parts.

Over the years, there has been an increase in interest in energy-efficient infrastructures and this is driving the research works in the field of load disaggregation. While attempts are being made to conserve energy, the focus has also been on how best the electricity consumption can be optimized by each appliance.

Load disaggregation may be useful in terms of both the consumers and producers of energy. The present-day supervised learning models for load disaggregation necessitate the learning of models for every appliance load of interest, which incurs high computational costs. Also, the amount of training data that is available in real-life is scarce and the models must be built with such a constraint in mind. The presence of common states like motor operation in certain appliances, are likely to make the supervised models vulnerable to errors; therefore, a trade-off between supervised and unsupervised is intended. Such models can easily adapt to OOD which is necessary criterion for problem at hand.

Embodiments of the present disclosure provide system and method that implement a Restricted Boltzmann Machine (RBM) based source-separation model with application to load disaggregation of appliances of interest. More specifically, the present disclosure provides a system and method for cognitive processing-based load disaggregation that use Restricted Boltzmann Machine (RBM) in a discriminative setup to obtain the semi-supervised approach to load disaggregation. Representations are learnt in an alternating fashion, between the power aggregate data and the appliance signatures, to output the mapping of data representations on the appliance signatures, for load disaggregation. Discriminative ability for each load/appliance of interest is achieved by adding the free energies of softmax layers of the RBM on other loads/appliance, as a discriminating gradient to the approximate gradients obtained on the load under consideration.

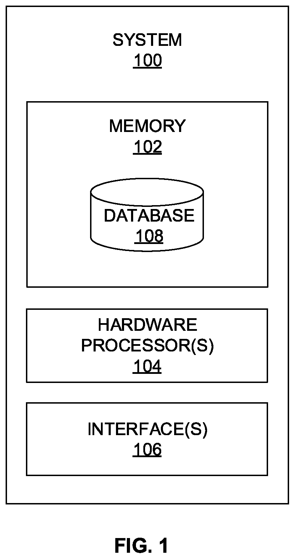

Referring now to the drawings, and more particularly to FIGS. 1 through 2, where similar reference characters denote corresponding features consistently throughout the figures, there are shown preferred embodiments and these embodiments are described in the context of the following exemplary system and/or method.

FIG. 1 depicts a system 100 for load disaggregation of appliances of interest using a Restricted Boltzmann Machine (RBM) based source-separation model, in accordance with an embodiment of the present disclosure. In an embodiment, the system 100 includes one or more hardware processors 104, communication interface device(s) or input/output (I/O) interface(s) 106 (also referred as interface(s)), and one or more data storage devices or memory 102 operatively coupled to the one or more hardware processors 104. The one or more processors 104 may be one or more software processing components and/or hardware processors. In an embodiment, the hardware processors can be implemented as one or more microprocessors, microcomputers, microcontrollers, digital signal processors, central processing units, state machines, logic circuitries, and/or any devices that manipulate signals based on operational instructions. Among other capabilities, the processor(s) is/are configured to fetch and execute computer-readable instructions stored in the memory. In an embodiment, the system 100 can be implemented in a variety of computing systems, such as laptop computers, notebooks, hand-held devices, workstations, mainframe computers, servers, a network cloud and the like.

The I/O interface device(s) 106 can include a variety of software and hardware interfaces, for example, a web interface, a graphical user interface, and the like and can facilitate multiple communications within a wide variety of networks N/W and protocol types, including wired networks, for example, LAN, cable, etc., and wireless networks, such as WLAN, cellular, or satellite. In an embodiment, the I/O interface device(s) can include one or more ports for connecting a number of devices to one another or to another server.

The memory 102 may include any computer-readable medium known in the art including, for example, volatile memory, such as static random-access memory (SRAM) and dynamic random-access memory (DRAM), and/or non-volatile memory, such as read only memory (ROM), erasable programmable ROM, flash memories, hard disks, optical disks, and magnetic tapes. In an embodiment, a database 108 is comprised in the memory 102, wherein the database 108 comprises input received by the system 100 in terms of smart meter data corresponding to a set of appliances. The database 108 further stores power consumption patterns corresponding to another set of appliances. The database 108 further stores information related to learning of one or more representations, discriminative output(s) of the RBM, mapped appliance power consumption patterns for each of appliance of interest, appliance signature(s), scheduling ON and OFF information specific to various appliances of interest, softmax information and partition function associated with the RBM, combinational outputs associated with softmax layers of the RBM, and the like.

The information stored in the database 108 further comprises various techniques such as scheduling technique(s) for scheduling ON and OFF of appliances for optimum utilization, propagation technique(s) (e.g., back propagation technique and the like) as known in the art, and the like. The above-mentioned techniques comprised in the memory 102/database 108 are invoked as per the requirement by the system 100 to perform the methodologies described herein. The memory 102 further comprises (or may further comprise) information pertaining to input(s)/output(s) of each step performed by the systems and methods of the present disclosure. In other words, input(s) fed at each step and output(s) generated at each step are comprised in the memory 102 and can be utilized in further processing and analysis.

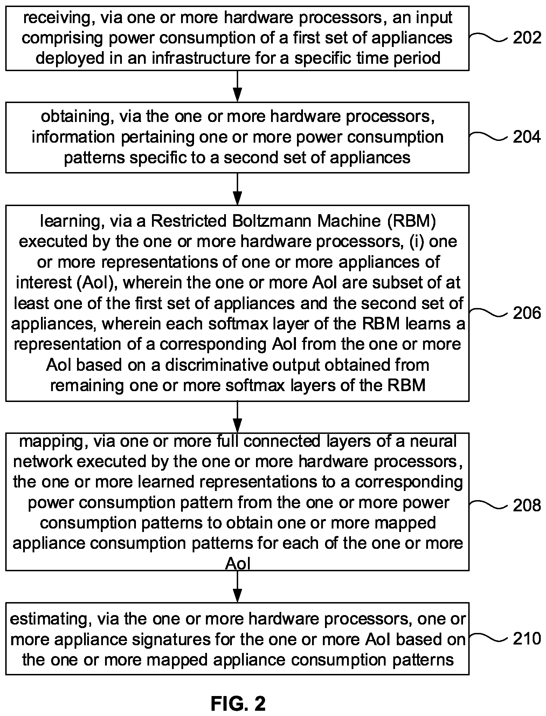

FIG. 2 depicts an exemplary flow chart illustrating a method for load disaggregation of appliances of interest using a Restricted Boltzmann Machine (RBM) based source-separation model, using the system 100 of FIG. 1, in accordance with an embodiment of the present disclosure. The system(s) 100 comprises one or more data storage devices or the memory 102 operatively coupled to the one or more hardware processors 104 and is configured to store instructions for execution of steps of the method by the one or more processors 104. The steps of the method of the present disclosure will now be explained with reference to components of the system 100 of FIG. 1, and the flow diagram as depicted in FIG. 2. In an embodiment, at step 202 of the present disclosure, the one or more hardware processors 104 receive an input (e.g., smart meter data) comprising power consumption of a first set of appliances deployed in an infrastructure for a specific time-period (or time interval). Example of the input power consumption pattern of the first set of appliances include but are not limited to: (i) a refrigerator typically consuming 150-200 watts in the normal state, microwave usually registers a spike of 1000- 1500 watts, a washer-dryer register a magnitude of 1500 watts approximately, followed by cyclic consumption states in the range (> 500 - < 1000 watts). It is to be understood by a person having ordinary skill in the art or person skilled in the art that the above example of smart meter data/ power consumption pattern of the first set of appliances are typical magnitudes and may differ with appliance make/manufacture slightly. Nevertheless, the patterns of consumption remain the same, in one example embodiment. In an embodiment, expressions consumption pattern and power consumption pattern may be interchangeably used herein.

In an embodiment, at step 204 of the present disclosure, the one or more hardware processors 104 obtain information (e.g., from a publicly available dataset) pertaining to one or more power consumption patterns specific to a second set of appliances. In an embodiment of the present disclosure, the system 100 collects historical aggregate and appliance signature data and segments them into N-length windows. The appliance data is usually collected such that it is representative of the usual power consumption patterns in the household, in one example embodiment. Example of infrastructures such as household(s) shall not be construed as limiting the scope of the present disclosure. In other words, the present disclosure may obtain smart meter data at step 202, and information from the publicly available dataset at step 204 from various premises such as corporate buildings, shopping malls, retail outlets, government offices, and the like. If a consumption vector comprising of 150-200 watts is observed for a period of one hour and a spike of 2000 watts appears thereafter towards the end of the observational window in the input aggregate data, the same is captured through a series of internal updations within the RBM till the point of obtaining a partition function and subsequently free energy (*F_{c}*). The first set of appliances and the second set of appliances may be different from each other, in one embodiment. The first set of appliances and the second set of appliances are identical, in another embodiment. The first set of appliances and the second set of appliances have at least a few appliances in common in terms of make, specification, brand, and the like, in yet another embodiment.

In an embodiment, at step 206 of the present disclosure, the one or more hardware processors 104 learn, via a RBM executed by the one or more hardware processors, one or more representations of one or more appliances of interest (AoI) to obtain one or more learned representations. The one or more representations comprise magnitude as mentioned above in step 202. In other words, the one or more representations comprise power consumption (or power consumption pattern) associated with a corresponding AoI, in one embodiment of the present disclosure. The one or more AoI are a subset of at least one of the first set of appliances and the second set of appliances. In other words, the one or more AoI are a subset of either the first set of appliances, or the second set of appliances or subset of the combinations thereof. In an embodiment, each softmax layer of the RBM learns a representation of a corresponding AoI from the one or more AoI based on a discriminative output obtained from remaining one or more softmax layers of the RBM. In one embodiment, each softmax layer of the RBM learns a representation of a corresponding AoI from the one or more AoI based on a discriminative output obtained from remaining one or more softmax layers amongst 'n' softmax layers of the RBM. Below description illustrates a process of inputting historical data (e.g., information obtained from the publicly available dataset) to the RBM and the appliance information is fed to various softmax layers of the RBM:

When the historical aggregate data is passed into a visible layer of the RBM, the partition function is computed and along with it the approximate gradients for the input aggregate data is also obtained. The historical aggregate data is transformed using the RBM and the free energy (*F_{c}*) is observed for the training period. Each of the softmax layers also registers non-linear transformation(s) for different appliance(s). The combinational transformations are learnt as a representation of the free energy of the RBM through a likelihood maximization approach! algorithm (e.g., the present disclosure implements likelihood maximization approach as known in the art).

On the other end of the RBM, softmax layers - each trained on an appliance's historical consumption data connected in parallel. The output of the softmax layers is related to the free energy of the RBM through an intermediate function. Through this function the occurrence of a windowed consumption *Pₗ* is related to the associated consumption contribution of all the appliances. If appliance *Aᵢ* → *Aₖ* was operational (or subset of the total set of appliances were operational), the disaggregated results are obtained through likelihood maximization objective function between the partition function due to aggregate data and the non-linear transformed states of appliances, which is equal to the least free energy combination of the appliance(s) of the RBM framework of the present disclosure.

Referring to the steps of FIG. 2, at step 208 of the present disclosure, the one or more hardware processors 104 map, via one or more full connected layers of a neural network executed by the one or more hardware processors, the one or more learned representations to a corresponding power consumption pattern from the one or more consumption patterns to obtain one or more mapped appliance consumption patterns (also referred as mapped appliance power consumption pattern) for each of the one or more AoI. The neural network (not shown in FIGS.) is comprised in the memory 102. As discussed above, on the other end, the softmax layers register the non-linear transformations for the power consumption patterns of different appliances of interest. Assuming that the appliances of interest are refrigerator, washer-dryer, microwave for this experiment. If during this window of observation for the aggregate data, if refrigerator was operational and registered the 150-200 watts and towards the end of the window if microwave was operated, the non-linearly transformed output of the softmax layers convey the same information (which is mapping information for each of the appliance of interest - in this case refrigerator, washer-dryer, microwave, and the like).

Referring to the steps of FIG. 2, at step 210 of the present disclosure, the one or more hardware processors 104 estimate one or more appliance signatures for the one or more AoI based on the one or more mapped appliance consumption patterns, the appliance signature is indicative or comprises an identifier and power consumption associated with an AoI. More specifically, the present disclosure and its system and the method use/implement a propagation technique/an efficient (appropriate) objective function or a backward propagation algorithm (the aforesaid intermediate function), to associate the free energy (*F_{c}*) with the softmax outputs. The combination of such associations yields least energy corresponds to the combination of appliances contributing to the observed input aggregate data. In this case, this algorithm is expected to yield the least free energy to the combination of the microwave and refrigerator.

The above description is better understood by way of the following illustration. In the method of the present disclosure, the system 100 obtains softmax information of a plurality of appliances from the first set and the second set of appliances wherein the softmax information is obtained through a softmax function of one visible layer of the RBM. The system also obtains a partition function z serving as an output of another visible layer of the RBM. In other words, the system 100 obtains (i) the softmax information through the softmax function of one visible layer of the RBM connected to the one or more softmax layers and (ii) the partition function z serving as an output of another visible layer of the RBM to the one or more softmax layers (wherein the softmax layers are either integral part of the system 100 or externally connected to the system 100 via the I/O interface(s) 106). The partition function z is obtained based on an input aggregate data fed to one visible layer of the RBM. Both the softmax information and the partition function z are then used as an input to learn combinational outputs of each layer of the RBM. In other words, partition function z of one visible layer of the RBM is added to the softmax information of every softmax layer of the RBM via a function to learn the one or more combinational outputs (e.g., free energy). Such combinational output is learnt by the system 100 via an intermediate function (not shown in FIGS.) implemented in the system 100. In other words, using the intermediate function, one or more combinational outputs of each layer of the RBM is learnt and this learning of the one or more combinational outputs is based on an interaction between the softmax information and the partition function *z*. The interaction of the softmax information and the partition function z is discussed in the mapping step 208. The combinational outputs (or combinational free energies) are learnt, and these outputs correspond to the input aggregate data. In other words, the during the test phase, the least possible free energy combination of appliances corresponds to the test aggregate data as received (e.g., test smart meter data). By performing the step of obtaining softmax information and partition function and learning the combinational outputs, the present disclosure ensures that there is a reduction in (i) computational efforts/cost(s) by the system and method and (ii) the complexity involved in the architecture. For instance, existing regression-based approaches require multiple instances of the network - one each to learn the aggregate data and appliance data association. The present disclosure is essentially stand-alone RBM which is used in the regressive context for the purpose of load disaggregation. This means that a single RBM is attached with softmax layers and this simplifies the network architecture to a great extent. This architecture obviously helps to also bring computational lightness to the problem of disaggregation.

Present disclosure and its system and method implement a Restricted Boltzmann Machine for load disaggregation of appliance of interest. In approximating the consumption data, RBMs demonstrate good accuracy. When the data is inherently structured, the RBM(s) capture the inherent structure of the data in the form of the partition function and the transformed output bears the same information too. As load consumption behaviour - that is the duration of operation, the pattern in which important appliances are usually operated, the typical duration of operation of appliances of interest - are usually structured, this structure is very important in general load disaggregation. However, any new pattern or appliance inclusion needs adequate/sufficient examples for training of RBM with the same. Generally, Auto Encoders or any other technique as compared to RBM appear to be less optimal in capturing the latent information in the consumption data. Also, the use of extended layers for training appliances seem to require simple (appropriate objective) function for mapping against the input aggregate data using RBM. Auto Encoders on the other hand are reported to use sophisticated iterative techniques to achieve the purpose of disaggregation.

The written description describes the subject matter herein to enable any person skilled in the art to make and use the embodiments.

It is to be understood that the scope of the protection is extended to such a program and in addition to a computer-readable means having a message therein; such computer-readable storage means contain program-code means for implementation of one or more steps of the method, when the program runs on a server or mobile device or any suitable programmable device. The hardware device can be any kind of device which can be programmed including e.g., any kind of computer like a server or a personal computer, or the like, or any combination thereof. The device may also include means which could be e.g., hardware means like e.g., an application-specific integrated circuit (ASIC), a field-programmable gate array (FPGA), or a combination of hardware and software means, e.g., an ASIC and an FPGA, or at least one microprocessor and at least one memory with software processing components located therein. Thus, the means can include both hardware means and software means. The method embodiments described herein could be implemented in hardware and software. The device may also include software means. Alternatively, the embodiments may be implemented on different hardware devices, e.g., using a plurality of CPUs.

The embodiments herein can comprise hardware and software elements. The embodiments that are implemented in software include but are not limited to, firmware, resident software, microcode, etc. The functions performed by various components described herein may be implemented in other components or combinations of other components. For the purposes of this description, a computer-usable or computer readable medium can be any apparatus that can comprise, store, communicate, propagate, or transport the program for use by or in connection with the instruction execution system, apparatus, or device.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include random access memory (RAM), read-only memory (ROM), volatile memory, nonvolatile memory, hard drives, CD ROMs, DVDs, flash drives, disks, and any other known physical storage media.

## Claims

1. A processor implemented method, comprising:
receiving, via one or more hardware processors (104) operatively coupled to a database (108), an input comprising power consumption of a first set of appliances deployed in an infrastructure for a specific time period (202), wherein the power consumption of the first set of appliances refer to magnitudes that differs among the first set of appliances, and power consumption patterns remain same among the first set of appliances;
obtaining, via the one or more hardware processors (104), information pertaining to one or more power consumption patterns specific to a second set of appliances (204), wherein the database (108) stores the power consumption of the first set of appliances, and the power consumption patterns of the second set of appliances, information related to learning of one or more representations, discriminative output(s) of a Restricted Boltzmann Machine (RBM), mapped appliance power consumption patterns for each of appliance of interest (AoI), appliance signature(s), scheduling ON and OFF information specific to various AoI, softmax information and partition function associated with the RBM, combinational outputs associated with softmax layers of the RBM, scheduling technique(s) for scheduling ON and OFF of the appliances for an optimum utilization, a back propagation technique;
learning, via the RBM executed by the one or more hardware processors (104), (i) one or more representations, comprising magnitudes, of the one or more appliances of interest (AoI), wherein the one or more AoI are a subset of at least one of the first set of appliances and the second set of appliances, wherein when the historical aggregate data is passed into a visible layer of the RBM the partition function z is computed and approximate gradients for the historical aggregate data is obtained, wherein the historical aggregate data is transformed using the RBM and the free energy (F_{c}) is observed for the training period, and each softmax layers of the RBM learns representation of a corresponding AoI from one or more AoIs based on discriminative output obtained from remaining one or more softmax layers of the RBM and each softmax layers also registers non-linear transformation(s) for different appliances and combinational transformations are learnt as a representation of the free energy (F_{c}) of the RBM through a likelihood maximization function,
wherein, through an intermediate function, the occurrence of a windowed consumption P*ₗ* is related to the associated consumption contribution of all the appliances, wherein when the subset of the total set of appliances are operational, the disaggregated results are obtained through the likelihood maximization objective function between the partition function z due to the historical aggregate data and non-linear transformed states of appliances, which is equal to least free energy combination of the appliances of the RBM;
mapping, via one or more full connected layers of a neural network executed by the one or more hardware processors, the one or more learned representations to a corresponding power consumption pattern from the one or more power consumption patterns to obtain one or more mapped appliance power consumption patterns for each of the one or more AoI (208), wherein each of the softmax layers register non-linear transformations for the one or more power consumption patterns of appliances of interest;
estimating, via the one or more hardware processors, one or more appliance signatures for the one or more AoI based on the one or more mapped appliance power consumption patterns (210), wherein the appliance signature is indicative of an identifier and power consumption associated with an AoI from the one or more AoI and implements the intermediate function to associate the free energy with softmax outputs and combinations of the associations yields least energy corresponds to a combination of appliances contributing to observed input aggregate data; and
invoking, via the one or more hardware processors, an AoI from the one or more AoI for scheduling on and off based on an appliance signature.

2. A system (100), comprising:
a memory (102) storing instructions and comprising a database (108);
one or more communication interfaces (106); and
one or more hardware processors (104) coupled to the memory (102) via the one or more communication interfaces (106), wherein the one or more hardware processors (104) are configured by the instructions to perform the method according to claim 1.

3. One or more non-transitory machine readable information storage mediums comprising one or more instructions which when executed by a system comprising a database (108) and one or more hardware processors (104) operatively coupled to the database, cause the system to perform a method according to claim 1.

## Patentansprüche

1. Prozessorimplementiertes Verfahren, umfassend:
Empfangen, über einen oder mehrere Hardwareprozessoren (104), die betriebsfähig mit einer Datenbank (108) gekoppelt sind, einer Eingabe, die einen Stromverbrauch eines ersten Satzes von Geräten umfasst, die in einer Infrastruktur für einen spezifischen Zeitraum (202) eingesetzt werden, wobei sich der Stromverbrauch des ersten Satzes von Geräten auf Größen bezieht, die sich unter dem ersten Satz von Geräten unterscheiden, und Stromverbrauchsmuster unter dem ersten Satz von Geräten gleich bleiben;
Erhalten, über den einen oder die mehreren Hardwareprozessoren (104), von Informationen, die sich auf ein oder mehrere Stromverbrauchsmuster beziehen, die für einen zweiten Satz von Geräten (204) spezifisch sind, wobei die Datenbank (108) den Stromverbrauch des ersten Satzes von Geräten und die Stromverbrauchsmuster des zweiten Satzes von Geräten, Informationen in Bezug auf das Lernen einer oder mehrerer Darstellungen, eine oder mehrere diskriminierende Ausgaben einer beschränkten Boltzmann-Maschine (RBM), abgebildete Gerätestromverbrauchsmuster für jedes von Geräten von Interesse (AoI), Gerätesignatur(en), Einplanungs-EIN- und -AUS-Informationen, die für verschiedene AoI spezifisch sind, Softmax-Informationen und eine Partitionsfunktion, die der RBM zugeordnet sind, kombinatorische Ausgaben, die Softmax-Schichten der RBM zugeordnet sind, eine oder mehrere Einplanungstechniken zum Einplanen von EIN und AUS der Geräte für eine optimale Nutzung, eine Rückpropagationstechnik speichert;
Lernen, über die RBM, die von dem einen oder den mehreren Hardwareprozessoren (104) ausgeführt wird, (i) einer oder mehrerer Darstellungen, die Größen umfassen, des einen oder der mehreren Geräte von Interesse (AoI), wobei das eine oder die mehreren AoI eine Teilmenge von mindestens einem des ersten Satzes von Geräten und des zweiten Satzes von Geräten sind, wobei, wenn die historischen aggregierten Daten in eine sichtbare Schicht der RBM weitergeleitet werden, die Partitionsfunktion z berechnet wird und ungefähre Gradienten für die historischen aggregierten Daten erhalten werden, wobei die historischen aggregierten Daten unter Verwendung der RBM transformiert werden und die freie Energie (F_{c}) für den Trainingszeitraum beobachtet wird, und jede Softmax-Schicht der RBM eine Darstellung eines entsprechenden AoI von einem oder mehreren AoI basierend auf einer diskriminierenden Ausgabe lernt, die von einer oder mehreren verbleibenden Softmax-Schichten der RBM erhalten wird, und jede Softmax-Schicht auch eine oder mehrere nichtlineare Transformationen für verschiedene Geräte registriert und kombinatorische Transformationen als eine Darstellung der freien Energie (F_{c}) der RBM durch eine Wahrscheinlichkeitsmaximierungsfunktion gelernt werden,
wobei, durch eine Zwischenfunktion, das Auftreten eines gefensterten Verbrauchs P*₁* mit dem assoziierten Verbrauchsbeitrag aller Geräte in Beziehung steht, wobei, wenn die Teilmenge des gesamten Satzes von Geräten betriebsfähig ist, die disaggregierten Ergebnisse durch die Wahrscheinlichkeitsmaximierungszielfunktion zwischen der Partitionsfunktion z aufgrund der historischen aggregierten Daten und nichtlinear transformierten Zuständen von Geräten erhalten werden, was gleich der niedrigsten freien Energiekombination der Geräte der RBM ist;
Abbilden, über eine oder mehrere vollständig verbundene Schichten eines neuronalen Netzwerks, das von dem einen oder den mehreren Hardwareprozessoren ausgeführt wird, der einen oder der mehreren gelernten Darstellungen auf ein entsprechendes Stromverbrauchsmuster aus dem einen oder den mehreren Stromverbrauchsmustern, um ein oder mehrere abgebildete Gerätestromverbrauchsmuster für jedes des einen oder der mehreren AoI (208) zu erhalten, wobei jede der Softmax-Schichten nichtlineare Transformationen für das eine oder die mehreren Stromverbrauchsmuster von Geräten von Interesse registriert;
Schätzen, über den einen oder die mehreren Hardwareprozessoren, einer oder mehrerer Gerätesignaturen für das eine oder die mehreren AoI basierend auf dem einen oder den mehreren abgebildeten Gerätestromverbrauchsmustern (210), wobei die Gerätesignatur eine Kennung und einen Stromverbrauch anzeigt, der mit einem AoI aus dem einen oder den mehreren AoI assoziiert ist, und die Zwischenfunktion implementiert, um die freie Energie mit Softmax-Ausgaben zu assoziieren, und Kombinationen der Assoziationen die geringste Energie ergeben, die einer Kombination von Geräten entspricht, die zu beobachteten aggregierten Eingangsdaten beitragen; und
Aufrufen, über den einen oder die mehreren Hardwareprozessoren, eines AoI aus dem einen oder den mehreren AoI zum Ein- und Ausschalten basierend auf einer Gerätesignatur.

2. System (100), umfassend:
einen Speicher (102), der Anweisungen speichert und eine Datenbank (108) umfasst;
eine oder mehrere Kommunikationsschnittstellen (106); und
einen oder mehrere Hardwareprozessoren (104), die über die eine oder die mehreren Kommunikationsschnittstellen (106) mit dem Speicher (102) gekoppelt sind, wobei der eine oder die mehreren Hardwareprozessoren (104) durch die Anweisungen konfiguriert sind, um das Verfahren nach Anspruch 1 durchzuführen.

3. Ein oder mehrere nichtflüchtige maschinenlesbare Informationsspeichermedien, die eine oder mehrere Anweisungen umfassen, die, wenn sie von einem System ausgeführt werden, das eine Datenbank (108) und einen oder mehrere Hardwareprozessoren (104) umfasst, die betriebsfähig mit der Datenbank gekoppelt sind, das System veranlassen, ein Verfahren nach Anspruch 1 durchzuführen.

## Revendications

1. Procédé mis en oeuvre par processeur, comprenant :
la réception, via un ou plusieurs processeurs matériels (104) couplés de manière opérationnelle à une base de données (108), d'une entrée comprenant une consommation d'énergie d'un premier ensemble d'appareils déployés dans une infrastructure pendant une période de temps spécifique (202), dans lequel la consommation d'énergie du premier ensemble d'appareils correspond à des magnitudes qui diffèrent parmi le premier ensemble d'appareils, et des modèles de consommation d'énergie restent les mêmes parmi le premier ensemble d'appareils ;
l'obtention, via les un ou plusieurs processeurs matériels (104), d'informations se rapportant à un ou plusieurs modèles de consommation d'énergie spécifiques à un second ensemble d'appareils (204), dans lequel la base de données (108) stocke la consommation d'énergie du premier ensemble d'appareils, et les modèles de consommation d'énergie du second ensemble d'appareils, des informations liées à l'apprentissage d'une ou plusieurs représentations, une ou plusieurs sorties discriminantes d'une machine de Boltzmann restreinte (RBM), des modèles de consommation d'énergie d'appareil mappés pour chacun d'un appareil d'intérêt (AoI), une ou plusieurs signatures d'appareil, des informations de planification ON et OFF spécifiques à divers AoI, des informations softmax et une fonction de partition associée à la RBM, des sorties combinatoires associées à des couches softmax de la RBM, une ou plusieurs techniques de planification pour la planification ON et OFF des appareils pour une utilisation optimale, une technique de rétropropagation ;
l'apprentissage, via la RBM exécutée par les un ou plusieurs processeurs matériels (104), (i) d'une ou plusieurs représentations, comprenant des magnitudes, des un ou plusieurs appareils d'intérêt (AoI), dans lequel les un ou plusieurs AoI sont un sous-ensemble d'au moins l'un du premier ensemble d'appareils et du second ensemble d'appareils, dans lequel lorsque les données agrégées historiques sont transmises dans une couche visible de la RBM, la fonction de partition z est calculée et des gradients approximatifs pour les données agrégées historiques sont obtenus, dans lequel les données agrégées historiques sont transformées en utilisant la RBM et l'énergie libre (F_{c}) est observée pendant la période d'apprentissage, et chaque couche softmax de la RBM apprend une représentation d'un AoI correspondant à partir d'un ou plusieurs AoI sur la base d'une sortie discriminante obtenue à partir d'une ou plusieurs couches softmax restantes de la RBM et chaque couche softmax enregistre également une ou plusieurs transformations non linéaires pour différents appareils et des transformations combinatoires sont apprises en tant que représentation de l'énergie libre (F_{c}) de la RBM par le biais d'une fonction de maximisation de vraisemblance,
dans lequel, par le biais d'une fonction intermédiaire, l'occurrence d'une consommation fenêtrée P*ₗ* est liée à la contribution de consommation associée de tous les appareils, dans lequel lorsque le sous-ensemble de l'ensemble total d'appareils est opérationnel, les résultats désagrégés sont obtenus par le biais de la fonction objectif de maximisation de vraisemblance entre la fonction de partition z due aux données agrégées historiques et des états transformés non linéaires d'appareils, qui est égale à la combinaison d'énergie libre minimale des appareils de la RBM ;
le mappage, via une ou plusieurs couches entièrement connectées d'un réseau neuronal exécuté par les un ou plusieurs processeurs matériels, des une ou plusieurs représentations apprises à un modèle de consommation d'énergie correspondant à partir des un ou plusieurs modèles de consommation d'énergie pour obtenir un ou plusieurs modèles de consommation d'énergie d'appareil mappés pour chacun des un ou plusieurs AoI (208), dans lequel chacune des couches softmax enregistre des transformations non linéaires pour les un ou plusieurs modèles de consommation d'énergie d'appareils d'intérêt ;
l'estimation, via les un ou plusieurs processeurs matériels, d'une ou plusieurs signatures d'appareil pour les un ou plusieurs AoI sur la base des un ou plusieurs modèles de consommation d'énergie d'appareil mappés (210), dans lequel la signature d'appareil est indicative d'un identifiant et d'une consommation d'énergie associée à un AoI à partir des un ou plusieurs AoI et met en oeuvre la fonction intermédiaire pour associer l'énergie libre à des sorties softmax et des combinaisons des associations produisent le moins d'énergie correspondant à une combinaison d'appareils contribuant à des données agrégées d'entrée observées ; et
l'appel, via les un ou plusieurs processeurs matériels, d'un AoI à partir des un ou plusieurs AoI pour la planification de la mise en marche et de l'arrêt sur la base d'une signature d'appareil.

2. Système (100), comprenant :
une mémoire (102) stockant des instructions et comprenant une base de données (108) ;
une ou plusieurs interfaces de communication (106) ; et
un ou plusieurs processeurs matériels (104) couplés à la mémoire (102) via les une ou plusieurs interfaces de communication (106), dans lequel les un ou plusieurs processeurs matériels (104) sont configurés par les instructions pour réaliser le procédé selon la revendication 1.

3. Un ou plusieurs supports de stockage d'informations lisibles par machine non transitoires comprenant une ou plusieurs instructions qui, lorsqu'elles sont exécutées par un système comprenant une base de données (108) et un ou plusieurs processeurs matériels (104) couplés de manière opérationnelle à la base de données, amènent le système à réaliser un procédé selon la revendication 1.
